(19) Europäisches Patentamt
European Patent Office
Office européen des brevets

(11) Publication number: 0 294 953 A2

(12) # EUROPEAN PATENT APPLICATION

(21) Application number: 88304535.3

(51) Int. Cl.4: G03F 7/10 , G03C 1/68

(22) Date of filing: 19.05.88

(30) Priority: 12.06.87 GB 8713740

(43) Date of publication of application: 14.12.88 Bulletin 88/50

(84) Designated Contracting States: AT BE CH DE ES FR GB GR IT LI LU NL SE

(71) Applicant: IMPERIAL CHEMICAL INDUSTRIES PLC
Imperial Chemical House Millbank
London SW1P 3JF(GB)

(72) Inventor: Lindley, Andrew Arthur
32 Bellemonte Road
Frodsham Cheshire(GB)
Inventor: Smith, Stephen
28 Honeydon Avenue
St.Neots Huntingdon Cambridgeshire(GB)

(74) Representative: Thomas, Ieuan et al
Imperial Chemical Industries PLC Legal Department: Patents PO Box 6 Bessemer Road
Welwyn Garden City Herts, AL7 1HD(GB)

(54) **Photopolymerisable compositions.**

(57) A photo-polymerisable composition which comprises (a) an oligomer bearing carboxyl groups and polymerisable definically unsaturated groups and (b) a compound which is reactive with the carboxyl can be used to produce permanent dry-film resists or solder masks. These products are developable in aqueous media.

EP 0 294 953 A2

## PHOTOPOLYMERISABLE COMPOSITIONS

This invention relates to compositions comprising polymerisable material and photo-initiator systems for the polymerisation thereof, and particularly to such compositions for use as dry-film resists and/or solder masks.

Dry-or tack-free film resists are known in the electronics art, for example as disclosed in US Patent Specification 3469982. Typically, such resists are formed from a solid photopolymerisable layer supported on a thin flexible polymeric support film and covered by a protective or cover film.

Recently so-called permanent or non-strippable dry-film resists have been developed which are capable of withstanding the harsh environments to which certain resists are subjected during the production of printed circuit boards by additive electroless copper plating. The use of permanent dry-film resists eliminates the removal of the resist which is a typical step during the manufacture of printed circuit boards.

In our copending European Patent Specifications Nos 145347A and 145345A it is disclosed that certain oligomers, which are derived from aromatic compounds and aldehydes, in admixture with a suitable photoinitiator system may be used to form permanent dry-film resists and solder masks respectively.

The known permanent dry-film resists and solder masks hereinbefore described have the disadvantage that organic solvents are required both in the preparation and development thereof.

US 4, 273, 857 and US 4, 435, 496 disclose photoresists derived from certain photopolymerisable compositions which after exposure to electromagnetic radiation, are developable by treatment with an alkaline solution.

We have now found that certain photopolymerisable oligomers which bear at least one carboxyl group in admixture with a compound reactive with the carboxyl group and a suitable photoinitiator system therefore may be used to form dry-film resists, particularly permanent dry-film resists, and a solder masks, which are developable in dilute solutions of bases.

According to the present invention there is provided a photopolymerisable composition comprising (a) at least one polymerisable olefinically unsaturated oligomer, which (i) comprises at least one in-chain residue of the general formula

$$— Ar^1 ——— CHR^1 ——— \qquad I$$

wherein $Ar^1$ is an aromatic group or a substituted aromatic group, $R^1$ is hydrogen or a hydrocarbyl group, (ii) has at least one pendant and/or terminal carboxyl group, and (iii) has one or more pendant and/or terminal acyloxymethyl groups in which the acyl group is derived from an olefinically unsaturated carboxylic acid (which polymerisable olefinically unsaturated oligomer is hereinafter referred to for convenience as "an aromatic/aldehyde oligomer"), (b) one or more substances which bear at least one group which is reactive with the at least one carboxyl group of the aromatic/aldehyde oligomer; and (c) a photoinitiator system for initiating polymerisation of the aromatic/aldehyde oligomer.

The aforesaid at least one polymerisable olefinically unsaturated oligomer may be linear or branched, and the at least one pendant and/or terminal carboxyl group therein may be attached directly or indirectly to the aromatic group $Ar^1$.

Preferably the carboxyl group is attached to the group $Ar^1$ by a divalent residue X which comprises one or more carbon and/or hetero atoms, i.e. the oligomer comprises at least one in-chain residue of general formula II.

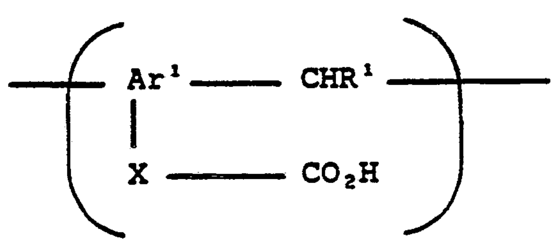 II

In a preferred aspect of the present invention the aromatic/aldehyde oligomer comprises, in addition to the at least one in-chain residue of general formula I, one or more residues of general formula

$$—\!\!\left( Ar^2 — CHR^2 \right)\!\!— \qquad III$$

wherein $Ar^2$, which may be the same as or different from $Ar^1$, is an aromatic group or a substituted aromatic group; and

$R^2$, which may be the same as or different from $R^1$, is hydrogen or a hydrocarbyl group.

The aromatic groups $Ar^1$ and $Ar^2$ may be mononuclear, e.g. as in phenylene; fused polynuclear, e.g. as in naphthalene or anthracene; or have the structure -Ø-$Y^1$-Ø-. In -Ø-$Y^1$-Ø, Ø is the phenylene group; $Y^1$ is a divalent residue which includes one or more in chain atoms, each of which atoms may be carbon or a hetero atom and may have one or more atoms appendant thereto, e.g. -O-, -S-, $-CH_2-$, or a substituted derivative of $-CH_2-$, e.g. $-C(CH_3)_2-$, $-CH_2CH_2-$, or

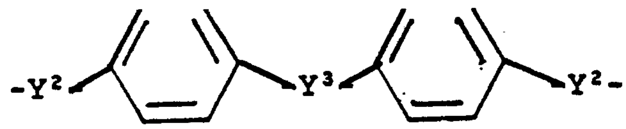

where $Y^2$, each of which may be the same or different, is a group which activates the aromatic nucleus to electrophilic attack, e.g. -O- and -S-, and $Y^3$ is a group which deactivates the aromatic nucleus to electrophilic attack, e.g. $-SO_2-$ and -CO-.

Photopolymerisable compositions according to the present invention in which $Ar^2$, where present in the aromatic/aldehyde oligomer, has a plurality of phenyl groups, e.g. diphenyl oxide, or fused phenylene rings, often polymerise to form resins faster than photopolymerisable compositions in which $Ar^2$ is absent.

Substituents which may be present on the aromatic groups $Ar^1$ and $Ar^2$ include inter alia lower alkyl groups having up to five carbon atoms, e.g. methyl and ethyl; lower alkoxy groups e.g. methoxy; and halo groups, e.g. chloro.

As a particularly preferred example of

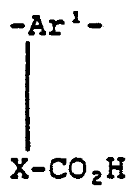

may be mentioned

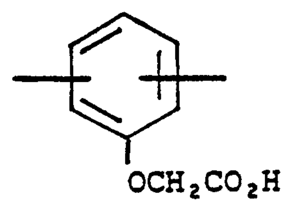

As a particularly preferred example of $Ar^2$ may be mentioned

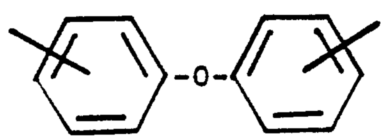

It will be appreciated that where photopolymerisable compositions according to the present invention comprises oligomers bearing groups such as

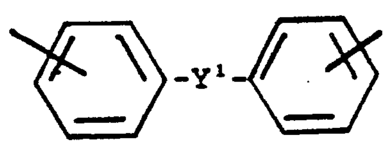

,

where $Y^1$ has the meaning hereinbefore ascribed to it, the groups $-CHR^1-$ and $-CHR^2-$, where $CHR^2-$ is present, may both be attached to the aromatic rings at positions para to $Y^1$ or one may be attached at a position on one aromatic ring which is para to $Y^1$ and the other may be attached at a position of the other aromatic ring which is ortho to $Y^1$.

As examples of suitable olefinically unsaturated carboxylic acids from which the aforesaid one or more pendant and/or terminal acyloxymethyl groups may be derived may be mentioned inter alia ethacrylic, crotonic, angelic, cinnamic, maleic, oleic and linoleic acids or preferably acrylic or methacrylic acid.

Where the groups $R^1$ and $R^2$ are hydrocarbyl groups they may be aryl groups, e.g. phenyl; alkaryl groups, e.g. tolyl; aralkyl groups, e.g. benzyl; or preferably alkyl groups having up to six carbon atoms, e.g. methyl or ethyl. We do not exclude the possibility that $R^1$ and $R^2$ may bear one or more suitable substituents, e.g. halo groups. Preferably, however, $R^1$ and $R^2$ are both hydrogen atoms.

As examples of the divalent residue X in general formula II may be mentioned inter alia $-OCH_2-$,

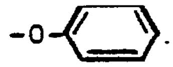

,$-CHR^1OCOCH=CH-$ and $-CHR^2OCOCH_2CH_2-$, where $R^1$ and $R^2$ have the meanings hereinbefore ascribed to them.

It will be appreciated that the functionality of aromatic/aldehyde oligomers of which photopolymerisable compositions according to the present invention are comprised will affect inter alia the viscosity and softening point of the oligomers and the mechanical properties of the cured resins prepared therefrom. For example, where the oligomer is a solid, a further substance may be added thereto such that a tack-free solid which is capable of lamination at a higher temperature, eg. 90-110°C, is obtained. It is often preferred that the functionality is between two and six. The skilled man by simple experiment will be able to determine satisfactory number average molecular weight/functionality combinations for the aromatic/aldehyde oligomers to achieve a desired combination of properties.

By "functionality" we mean the number of acyloxymethyl groups per aromatic/aldehyde oligomer molecule.

Where X in aromatic/aldehyde oligomers for use in the present invention represents $-OCH_2-$ or

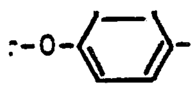

such oligomers may be prepared from phenoxyacetic acid or phenoxybenzoic acid as is more fully described in our copending European Patent Specification No. 162651.

Where, in aromatic/aldehyde oligomers for use in the present invention, X in the General Formula II represents $-CH_2OCOCH=CH-$ such oligomers may be prepared from the reaction of, for example, diphenyl oxide, formaldehyde, methacrylic acid and maleic acid as is more fully described in US 3,914,194.

Where in aromatic/aldehyde oligomers for use in the present invention the carboxyl group is attached to the aromatic residue $Ar^1$ by the divalent residue $-CH_2OCOCH=CH-$ such oligomers may be prepared by reacting maleic anhydride with an appropriate hydroxymethyl substituted oligomer as is more fully described in US 4,045,410.

Where in aromatic/aldehyde oligomers for use in the present invention the carboxyl group is attached directly to the aromatic residue $Ar^1$ such oligomers may be prepared by oxidation of an appropriate hydroxymethyl substituted oligomer as is more fully described in our aforesaid European Patent Specification No. 0112650A.

The disclosures in the aforementioned patent specifications are incorporated herein by way of reference.

The concentration of the at least one aromatic/aldehyde oligomer in photopolymerisable compositions according to the present invention is preferably more than 60% w/w and more preferably is at least about 75% w/w.

The one or more substances which bear at least one group which is reactive with the carboxyl group of the aromatic/aldehyde oligomer will be chosen in the light of its physical state and its reactivity with the carboxyl group. It is preferred that the substance is solid at room temperature such that it does not unduly inhibit formation of a substantially tack-free layer from the photopolymerisable composition of the present invention. For example, where the substance provides about 10-20%, say, of the composition it is typically a solid such that it does not unduly inhibit production of a tack-free solid at room temperature from the composition. Furthermore, it is preferred that its reactivity is such that (a) it is substantially inert to reaction at room temperature with the carboxyl group on the aromatic/aldehyde oligomer, thus allowing storage of the photopolymerisable composition; and (b) reacts rapidly at elevated temperature, say of the order of about 160°C, with the carboxyl group on the exposed portions of the resist to produce a product which is resistant to alkalis.

As examples of the one or more substances which bear at least one group which is reactive with the carboxyl group of the aromatic/aldehyde oligomer may be mentioned suitable amines, e.g. 4,4'-diaminodiphenyl methane, imidazolines, oxazolines, or preferably epoxides.

The concentration of the one or more substances which bear at least one group which is reactive with the carboxyl group in the aromatic/aldehyde oligomer in photopolymerisable compositions according to the present invention is preferably less than 30% w/w and more preferably is between 10 and 20% w/w. It will be appreciated that the relative amounts of aromatic/aldehyde oligomer and substance reactive therewith will be chosen in the light of inter alia the molecular weights thereof, the number of carboxyl groups present

in the aromatic/aldehyde oligomer and the number of carboxyl-reactive groups present in the aforesaid substance.

The photoinitiator system for use in the present invention may comprise any of the known photo-initiator systems which are used to initiate polymerisation of polymerisable olefinically unsaturated monomers. As examples of such systems can be mentioned inter alia (a) mixtures of Michler's ketone and benzil or preferably benzophenone, typically in a weight ratio of about 1:4; (b) mixtures of amines and ketones as disclosed in our EP 90493A, e.g. camphorquinone or fluorenone and N,N-dimethylaminoethyl methacrylate, typically in a weight ratio of about 1:1, (c) the coumarin based photoinitiator systems described in US 4,289,844, (d) combinations of hexaarylbisimidazoles and leuco dyes, (e) cyclohexadinone-leuco dye systems described in US 4,241,869, or (f) systems based on dimethoxyphenyl acetophenone (benzil dimethyl ketal) and/or diethoxyacetophenone.

The concentration of the photoinitiator system used in the photopolymerisable composition of the present invention is typically up to about 10% w/w.

We do not exclude the possibility that photopolymerisable compositions according to the present invention may contain a peroxy initiator, but this is not preferred.

Optionally photopolymerisable compositions according to the present invention on exposure to actinic radiation of a wavelength which is absorbed by the photo-initiator system interact therewith such that a contrast between exposed and unexposed regions of the polymerisable composition is generated. For example, where the polymerisable composition is colourless a colour may be generated in the exposed region thereof, or preferably, where the photopolymerisable composition is coloured, the colour disappears or changes in the exposed region thereof. For the generation of such a contrast, the photopolymerisable composition preferably contains a light-sensitive system which absorbs the aforesaid actinic radiation. As examples of such light sensitive systems may be mentioned inter alia leuco dyes, e.g. crystal violet; fluoran and a compound which generates an acid on exposure to suitable actinic radiation e.g. $Ph_3S^+PF_6^-$; and a combination of a light-fast dye, typically blue in colour, and a light-unstable dye, typically yellow in colour.

Photopolymerisable compositions according to the present invention may contain a pigment or dyestuff which typically is green, for example a phthalocyanine green, such that a photo-resist or solder mask of conventional colour is produced.

Photopolymerisable compositions according to the present invention typically contain processing aids. As examples of processing aids may be mentioned inter alia agents which act as at least one of the following: surfactant, flow modifier or anti-blocking agent. Suitable such agents are well known in the art and include inter alia $CF_3(CF_2CF_2)_{17}CH_2CH_2OCO(CH_2)_{16}CH_3$ or preferably a silicone acrylate or more preferably a silicone diacrylate.

Photopolymerisable compositions according to the present invention may contain a particulate filler, e.g. a silica. It will be appreciated that where a particulate filler is present it does not unduly adversely affect the properties of the photopolymerisable composition. However, the presence of a particulate filler is not preferred.

Photopolymerisable compositions according to the present invention typically contain a suitable thermal polymerisation inhibitor. As examples of such inhibitors may be mentioned inter alia p-methoxyphenol, hydroquinone, alkyl- and aryl- substituted hydroquinones and quinones, and t-butyl catechol. Such inhibitors are used in a concentration of up to a few weight % of the photopolymerisable composition.

We do not exclude the possibility that photopolymerisable compositions according to the present invention may contain a polymeric binder. Suitable polymeric binders are thermoplastics which on addition to solutions of the at least one aromatic/aldehyde oligomer in a suitable solvent increase the viscosity of such solutions, tend to reduce the tackiness of solid layers deposited therefrom and do not unduly inhibit dissolution of the uncured photopolymerisable composition in the washing solvent during the development step of the dry film resist or solder mask. They often have molecular weights of between 10,000 and 1,000,000, preferably between 20,000 and 100,000.

It will be appreciated that polymeric binders for use in the present invention will have Tg's above 20°C. Preferably they have Tg's between 50°C and 120°C.

Preferably polymeric binders for use in the present invention have good thermal stability and do not unduly adversely affect the rate of polymerisation of the photopolymerisable composition.

To facilitate dissolution of the polymeric binder in the aforementioned washing solvent it is often preferred that it bears a polar substituent, more preferably a carboxyl substituent.

As examples of suitable polymeric binders may be mentioned inter alia polyvinyl pyrrolidone, vinyl pyrrolidone/vinyl acetate copolymers, methacrylate/methacrylic acid copolymers and the polymeric binders disclosed in US 3,458,311, UK 3,448,089, US 4,239,849, US 3,953,309 and UK 1,507,704.

Polymeric binders, where they are present in photopolymerisable compositions according to the present

invention, typically provide less than 30% w/w and preferably less than 20% w/w of the photopolymerisable composition. The amount of polymeric binder used in photopolymerisable compositions according to the present invention, and the Tg thereof, will be chosen in the light of the conditions under which a three-layer element is prepared from the photopolymerisable composition as hereinafter described. Use of too much polymeric binder tends to lead to a flaky layer of the photopolymerisable composition in the three-layer element.

We do not exclude the possibility that photopolymerisable compositions according to the present invention may contain one or more substance which bear one or more polymerisable olefinically unsaturated groups and which is (are) copolymerisable with the at least one aromatic/aldehyde oligomer. Such substances are hereinafter referred to for convenience as "comonomers".

As examples of comonomers which may be present in photopolymerisable compositions according to the present invention may be mentioned inter alia N-vinyl pyrrolidone, water-soluble N-alkyl acrylamides and hydroxyalkyl (meth)acrylates, e.g. 2-hydroxyethyl methacrylate.

Preferably, comonomers, where present in photopolymerisable compositions according to the present invention, are low viscosity compounds containing a plurality of polymerisable olefinically unsaturated groups. As examples of such compounds may be mentioned (alk)acrylic acid esters of polyhydroxy compounds, for example, diethylene glycol, trimethylolpropane and pentaerythritol, eg. triethylene glycol dimethacrylate and trimethylolpropane trimethacrylate.

Conveniently photopolymerisable compositions according to the present invention are used in the form of a three-layer element in which a layer of the photopolymerisable composition, preferably in the form of a solid or tack-free layer, is sandwiched between a support film and cover film. However we do not exclude the possibility that a suitable substrate, as hereinafter described, may be coated directly with the photopolymerisable composition, for example by deposition from a suitable solvent.

As examples of suitable polymers of which support films used in the preparation of permanent dry film resists may be comprised may be mentioned inter alia polyamides, polyolefins, vinyl polymers, cellulose or preferably polyesters, more preferably polyethylene terethphalate. Preferably, the support film transmits actinic radiation of a wavelength which is to be used to cure the photopolymerisable composition. Preferably the support film is substantially impermeable to oxygen. The thickness of the support film may be between 5 microns and 200 microns, and typically is between 10 microns and 50 microns.

Cover films used in the preparation of permanent dry film resists may be made from a polymer which has hereinbefore been indicated as suitable for preparation of the support film. Preferably the cover film comprises a polyolefin, and more preferably comprises polyethylene. The thickness of the cover film may be between 5 microns and 200 microns, and typically is between 20 microns and 50 microns.

Where a photopolymerisable composition of the present invention is used in a three-layer element it is typically in the form of a substantially dry tack-free layer of thickness between 10 and 100 microns.

Whilst the photopolymerisable composition is preferably applied to the support film as a solution in a suitable solvent and the solvent evaporated off to leave a substantially tack-free solid layer, we do not exclude the possibility that it may be heated and applied in a softened state to the support film. The cover film is then laminated to the solid layer to provide a three-layer element.

As examples of suitable solvents from which the tack-free solid layer may be cast may be mentioned inter alia methyl ethyl ketone, and 1,1,1-trichloro ethane.

In use, the cover film is removed from the three-layer element and the exposed surface of the solid layer of photopolymerisable composition is brought into contact with a suitable base-board or pointed circuit and laminated to a surface thereof, for example using resilient heated pressure rolls. (It will be appreciated that where the photopolymerisable composition is used in the preparation of a solder mask the temperature and pressure at which the laminating step is carried out are such that the layer of the photopolymerisable composition is forced to conform to the contours of the printed circuit board such that encapsulation of the conductors occurs without excessive thinning of the layer or puncture thereof by the conductors.) The photopolymerisable composition is then exposed imagewise, preferably through the support film, to electromagnetic radiation having a wavelength in the range 250 to 600 nanometres, preferably in the range of 320 nanometres to 500 nanometres; the support film is removed, for example by peeling off; and the resist or solder mask is developed by washing away the unexposed areas with a suitable washing solvent, to leave a base-board bearing a relief resist on its surface or a printed circuit board one face of which, except for the area(s) thereof to which a solder is to be applied, is covered by a solder mask. The resist or solder mask is then post-cured by heating at a temperature in the range of, for example, 120° C to 180° C, and optionally may be subjected to UV irradiation. During the post-curing step, the carboxyl group in the aromatic/aldehyde oligomer reacts with the one or more substances which bear at least one group which is reactive with the carboxyl group such that the susceptibility of the cured photopolymerisable composition to

attack by alkali is reduced.

The aqueous washing solvent is a dilute aqueous solution of a suitable base. Whilst we do not exclude the possibility that the suitable base may be an organic amine, for example having a base-ionization constant greater than about 1 X $10^{-6}$, e.g. benzylamine, dimethylamine, or trimethylamine, it is preferred that the base is inorganic, e.g. ammonia, borax, a phosphate or preferably an alkali metal hydroxide or the base-reacting alkali metal salts of weak acids, e.g. sodium carbonate or bicarbonate.

By "dilute" we mean a concentration of up to a few per-cent weight/weight, e.g. 2%, or up to a few molar, e.g. IM.

Optionally, the suitable aqueous washing solvent may contain a small per-centage, up to 10% v/v, say, of a suitable non-volatile organic liquid, e.g. 2-butoxy-ethanol, to improve the dissolution of the photopolymerisable composition.

The particular washing solvent used will be chosen in the light of the strength and concentration of the carboxyl groups in the photopolymerisable composition.

The washing is conveniently carried at between 10° C and 40° C, typically for less than ten minutes, e.g. about two minutes.

It will be appreciated that where a photopolymerisable composition according to the present invention is used in the production of a resist and where the resist is generated on a copperised surface of the base-board the non-protected copper may be removed in a so-called "subtractive process". Preferably, however, the resist is used as a permanent or non-strippable resist in a so-called "additive process" in which metal, e.g. copper, is deposited on the bare portion of the surface of a suitable substrate, between the areas of photoresist, e.g. by electroless plating and then optionally by electrolytic deposition. As examples of suitable substrates may be mentioned ceramic plates or conventional base-boards used for additive plating, e.g. an epoxy glass composite as used in Kollmorgen PCK Technologies CC-4 additive plating process.

Where photopolymerisable compositions according to the present invention are used in the production of resists which are to be used in an additive process it is often preferred that they do not contain sulphur or those sulphur-containing compounds which have a tendency to affect adversely the plating bath.

The resists and solder masks prepared from the photopolymerisable compositions of the present invention are, after post-curing, often (a) able to withstand sodium hydroxide solution at pH12 and 80° C for 20 hours; chromic acid at pH1 and 45° C for 20 minutes; and a solder float test at 285° C for 30 seconds without blistering or loss of adhesion; and (b) are resistant to attack by methylene chloride for 1 minute at ambient temperature with little or no change in surface hardness or appearance. Accordingly, a further aspect of the present invention provides a process for the preparation of a non-strippable resist or a solder mask on a surface which process comprises the steps of:

(a) applying to the surface a first surface of a solid layer of a photopolymerisable composition as hereinbefore defined, the second surface of the said solid layer having adhering thereto a thin flexible polymeric support film, then in either order;

(b) exposing the layer, imagewise, to actinic radiation such that a polymeric image is generated in the layer; and

(c) stripping the support film from the layer; then

d) washing away the unexposed areas of the layer with a suitable aqueous basic washing solvent such that a relief image of polymeric material is produced; and

(e) thermally post-curing the resist image.

The present invention is further illustrated by reference to the following Examples.

## Examples 1-10

These Examples illustrate the preparation of solid tack-free layers comprising photopolymerisable compositions according to the present invention.

A solution of aromatic/aldehyde oligomer, epoxide resin, photoinitiator system (Irgacure 651 (RTM), except Example 8, where Irgacure 651 (RTM) and Quantacure EPD (RTM) (ethyl-4-dimethylamino benzoate) were used in a weight ratio of 32.5:1), and pigment (Monastral Green GBN (RTM)) in methyl ethyl ketone was coated onto a Melinex (RTM) support film, 23 microns thick. Prior to use, silicone acrylate was added to the solution at a concentration of 0.1 %w/w.

The coating was applied using a wire-wound coating bar and had a wet thickness of 125 microns. The

wet coating was dried with a hot air blower, and then allowed to stand. After 2 hours, the film was slightly tacky; after 24 hours, it was tack-free and had a thickness of 30 to 35 microns.

The compositions of the tack-free solid layers and the concentration of the aforementioned solutions are given in Table 1.

TABLE 1

| Ex No. | Composition of Tack-Free Layer (%w/w) | | | | Concentration of Solution (%w/w) |
|---|---|---|---|---|---|
| | Oligomer | Epoxy Resin | Photo-initator system | Pigment | |
| 1 | A 80.0 | C 11.0 | 8.4 | 0.6 | 58% |
| 2 | A 80.0 | D 11.0 | 8.4 | 0.6 | 58% |
| 3 | A 84.0 | C 9.3 | 6.5 | 0.2 | 45% |
| 4 | A 79.2 | C 14.1 | 6.5 | 0.2 | 45% |
| 5 | A 74.7 | C 18.6 | 6.5 | 0.2 | 45% |
| 6 | A 79.2 | F 14.0 | 6.5 | 0.4 | 45% |
| 7 | A 79.2 | E 14.0 | 6.5 | 0.4 | 45% |
| 8 | B 76.5 | D 16.6 | 6.7 | 0.3 | 45% |
| 9 | A 76.2 | D 16.2 | 6.5 | 0.3 | 45% |
| 10 | A 79.0 | F 14.1 | 6.6 | 0.3 | 43% |

A) An aromatic/aldehyde oligomer prepared as described in Examples 5 and 6 of EP 162651 having Mn 576 Mw 3907 and Mw/Mn 6.78.

B) An aromatic/aldehyde oligomer prepared as described in Examples 5 and 6 of EP 162651 having Mn 884 Mw 8404 and Mw/Mn 9.51.

C) Epikote 1001 (RTM): Bisphenol-A-epichlorohydrin epoxide resin with epoxy group content 2000-2220 mmol/kg and Mn 900.

D) Epikote 1055 (RTM): Bisphenol-A-epichlorohydrin epoxide resin with epoxy group content of 1110-1250 mmol/kg and Mn 1350.

E) Araldite 6100 (RTM) Bisphenol-A-epichlorohydrin epoxide resin with epoxide content 2.0-2.15 mol/kg and low molecular weight.

F) Araldite G7004 (RTM) Bisphenol-A-type solid epoxy resin with epoxide content of 1.20-1.45 and medium molecular weight.

Examples 11-17

These Examples illustrate the preparation of permanent dry film resists form photopolymerisable compositions according to the present invention.

The bare surface of the tack-free layers prepared in Examples 1 to 7 were separately contacted with the surface of a conventional board as used in the Kollmorgan PCK Technologies CC-4 "additive" process (which had been scrubbed under water with Scotch-Brite (RTM) and dried) and laminated thereto using a Dynachem (RTM) Model 300 laminator at 100°C and a throughput speed of 1.5 feet per minute. Laminates which comprised a board, a polymerisable layer and a Melinex (RTM) support film were obtained.

The laminate was allowed to cool for 30 minutes before use, it was then exposed, through a Stouffer 21-step sensitivity guide disposed on Melinex (RTM) film, to UV radiation (Parker Graphics LTD, "Countess" exposure unit provided with two MLV 300 w Philips UV lamps) for 12 minutes. After exposure, the resists were stored for 30 minutes at room temperature. The Melinex (RTM) support film was removed and the tack-free layer was washed in 2% aqueous sodium carbonate solution for 2 minutes, at room temperature, using an ultra-sonic bath and then rinsed in water. A cured resin which was resistant to washing was obtained at steps up to and including the steps indicated by the step-wedge numbers shown in Table 2.

Table 2

| Example No. | Solid Layer From Example No. | Stepwedge No. obtained |
|---|---|---|
| 11 | 1 | 9/10 |
| 12 | 2 | 8/9 |
| 13 | 3 | 8/9 |
| 14 | 4 | 9 |
| 15 | 5 | 9 |
| 16 | 6 | 9 |
| 17 | 7 | 10 |

Examples 11-17 were repeated except that (a) a Stouffer step wedge was not used, and (b) after removal of the Melinex (RTM) support film, the washing step was omitted. The cured layer was post-cured by exposure to heat or a combination of heat and exposure to UV light from a Philips HPR 125W murcury discharge lamp at a distance of 40 centimetres as indicated in Table 3.

The post-cured layer was subjected to pH 12.7 aqueous sodium hydroxide solution at 80°C. The results obtained are shown in Table 3.

The laminate of the board and post-cured layer was dipped into multi-core rosin flux PC26. After flux-treatment, a first portion was placed, resist surface down,

Table 3

| Example No. | Heat Cure | Light Cure | Exposure to NaOH Solution | |
|---|---|---|---|---|
| | | | Time (hours) | Condition of Layer |
| 11(a) | 1 hour 155°C-160°C | | 24 | good |
| 11(b) | 1 hour 155°C-160°C | 1 hour | 24 | good |
| 12(a) | 1 hour 155°C-160°C | - | 24 | good |
| 12(b) | 1 hour 155°C-160°C | 1 hour | 24 | good |
| 13(a) | ½ hour 155°C | - | 16 | poor |
| 13(b) | 1 hour 155°C | - | 16 | poor |
| 13(c) | 2 hour 155°C | - | 24 | good |
| 14(a) | ½ hour 155°C | - | 16 | poor |
| 14(b) | 1 hour 155°C | - | 16 | mediocre |
| 14(c) | 2 hour 155°C | - | 24 | good |
| 15(a) | ½ hour 155°C | - | 24 | mediocre |
| 15(b) | 1 hour 155°C | - | 24 | good |
| 15(c) | 2 hour 155°C | - | 24 | good |
| 16 | 1 hour 160°C | - | 24 | good |
| 17 | 1 hour 160°C | - | 24 | good |

for 30 seconds on a 60:40 tin-lead solder bath at 285° C, a second portion was placed, resist surface down, on the solder bath for 6 seconds, removed for 21 seconds, contacted for a further 6 seconds and removed. Both portions were cleaned using 1,1,1-trichloroethylene, and the resist surface was found to be neither dulled nor blistered.

A 2mm cross hatch pattern was produced on both portions and on an unsoldered piece of resist material. Pieces of 3M Scotch (RTM) 610 tape were pressed firmly against the cross-hatched surfaces, and removed with a sharp tug. In all cases 100% retention of resist was observed.

Examples 11-17 were again repeated except that the laminate was exposed, for 12 min, through a standard phototool, having 170 micron lines and spaces, disposed on Melinex (RTM) film. Twenty minutes after the end of exposure, the Melinex (RTM) film was removed and the solid layer was washed in 2% aqueous sodium carbonate solution for 2 minutes and then rinsed in water. A resist pattern consisting of approximately 170 micron spaces and lines was thereby produced.

Examples 18-20

These Examples illustrate the use of permanent dry film resists prepared by the process of the present invention in the Kollmorgen PCK Technologies "additive" process.

Portions of the tack-free layers prepared in Examples 8-10 were applied to the surface of conventional board as used in the Kollmorgen PCK Technologies CC-4 "additive" process, as described in Examples 11-17. The laminates of circuit board, tack-free layer and Melinex (RTM) so produced, were exposed, for 12 minutes, through a standard photo-tool, having a circuit design disposed on the Melinex (RTM) film. 30 minutes after the end of exposure, the solid layer was washed with 2% aqueous sodium carbonate solution for 2 minutes (Examples 18 and 19). Example 20 was washed in cold molar sodium hydroxide solution and rinsed in water. All samples were post-cured after washing for 1 hour at 160° C.

Plating was conducted using the "CC4 additive" process developed by Kollmorgan PCK Technologies. Examples 18 and 19 were examined after 8 hours plating at 65° C. No surface defects were noted and no build-up of extraneous copper on the resist surface had occurred. Further samples were allowed to stand in the plating solution for 24 hours at 65° C. No adverse effects were noted. The resist prepared in Example 10 was plated for 24 hours, the sample again had no surface defects.

## Claims

1. A photopolymerisable composition comprising

(a) at least one polymerisable olefinically unsaturated oligomer which

i) comprises at least one in-chain residue of the general formula

$-Ar^1-CHR^1-$

wherein $Ar^1$ is an aromatic group or a substituted aromatic group and $R^1$ is hydrogen or a hydrocarbyl group;

ii) has at least one pendant and/or terminal carboxyl group; and

iii) has one or more pendant and/or terminal acyloxymethyl groups in which the acyl group is derived from an olefinically unsaturated carboxylic acid;

(b) one or more substances which bear at least one group which is reactive with the at least one pendant and/or terminal carboxyl group; and

(c) a photoinitiator system for initiating polymerisation of the oligomer.

2. A photopolymerisable composition as claimed in claim 1 wherein the at least one pendant and/or terminal carboxyl group is attached to the group $Ar^1$ by a divalent residue which comprises one or more carbon and/or hetero-atoms.

3. A photopolymerisable composition as claimed in claim 1 wherein the oligomer comprises in addition to the at least one in-chain residue $-Ar^1-CHR^1-$, one or more in-chain residues of the general formula

$-Ar^2-CHR^2-$

wherein

$Ar^2$, which may be the same as or different from $Ar^1$, is an aromatic group or a substituted aromatic group; and

$R^2$, which may be the same as or different from $R^1$, is hydrogen or a hydrocarbyl group.

4. A photopolymerisable composition as claimed in claim 3 wherein $Ar^2$ comprises a plurality of phenylene groups.

5. A photopolymerisable composition as claimed in claim 2 wherein $Ar^1$ has the structure

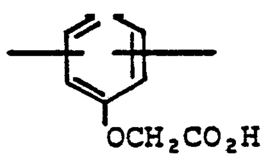

6. A photopolymerisable composition as claimed in claim 4 wherein $Ar^2$ has the structure

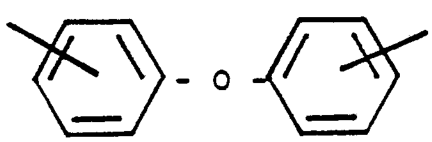

7. A photopolymerisable composition as claimed in claim 1 wherein the olefinically unsaturated carboxylic acid from which the one or more pendant and/or terminal acyloxymethyl groups is derived is acrylic or methacrylic acid.

8. A photopolymerisable composition as claimed in claim 1 or 3 wherein both $R^1$ and $R^2$, where it is present, are hydrogen.

9. A photopolymerisable composition as claimed in claim 1 wherein the one or more substances bears an epoxide group.

10. A photopolymerisable composition as claimed in claim 1 wherein the photo-initiator system comprises benzophenone.

11. A three-layer element comprising a solid or tack-free layer of a photopolymerisable composition as claimed in claim 1 sandwiched between a support film and a cover film.

12. A process for the preparation of a three-layer element as claimed in claim 11 which process comprises the steps of:

(a) producing a layer of the photopolymerisable composition on a support film; and

(b) laminating a cover film to the exposed surface of the layer of the photopolymerisable composition.

13. A process for the preparation of a non-strippable resist or a solder mask on a surface which process comprises the steps of:

(A) applying to the surface, a first surface of a solid or tack-free layer of a photopolymerisable composition as claimed in claim 1, the second surface of the solid layer having adhering thereto a thin flexible polymeric support film, then in either order;

(B) exposing the layer, imagewise, to actinic radiation such that a polymeric image is generated in the layer; or

(C) stripping the support film from the layer; then

(D) washing away the unexposed areas of the layer with a suitable aqueous basic washing solvent such that a relief polymeric image is produced on the surface; and

(E) thermally post-curing the polymeric image by reaction with the one or more substances.

14. A process as claimed in claim 13 wherein the washing solvent used in Step D comprises an inorganic base.

15. A process as claimed in Claim 13 further characterised in that a layer of metal is deposited on the bare portion of the surface between the relief polymeric image.